(19) Europäisches Patentamt / European Patent Office / Office européen des brevets

(11) **EP 4 606 631 A1**

(12) **EUROPEAN PATENT APPLICATION**

(43) Date of publication:
27.08.2025 Bulletin 2025/35

(21) Application number: 24159438.1

(22) Date of filing: 23.02.2024

(51) International Patent Classification (IPC):
**B60L 53/14** (2019.01)   **B60L 53/62** (2019.01)
**B60L 3/00** (2019.01)   **B60L 53/16** (2019.01)
**B60L 53/30** (2019.01)   **B60L 55/00** (2019.01)
**B60L 58/15** (2019.01)   **B60L 53/66** (2019.01)
**B60L 3/12** (2006.01)

(52) Cooperative Patent Classification (CPC):
**B60L 53/62; B60L 3/0046; B60L 53/16;
B60L 53/305; B60L 53/66; B60L 55/00;
B60L 58/15; G01R 31/382;** B60L 3/12;
B60L 2240/527; B60L 2240/529; B60L 2240/547;
B60L 2240/549; B60L 2240/80; B60L 2260/42;
(Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ABB E-mobility B.V.**
2629 JG Delft (NL)

(72) Inventor: **Lars, BECH**
3119 JA Schiedam (NL)

(74) Representative: **Zimmermann & Partner
Patentanwälte mbB
Postfach 330 920
80069 München (DE)**

(54) **METHOD AND EV SUPPLY EQUIPMENT FOR CHARGING AN EV BATTERY**

(57) The application concerns a method for charging or discharging an EV battery of an Electrical Vehicle, EV, using an Electrical Vehicle Supply Equipment, EVSE. The method comprises: Electrically coupling an EVSE charging interface conductor of the EVSE to an EV charging interface conductor of the EV and Determining, by the EVSE, an EV Present Voltage provided by the EV battery at the inlet; and at least one of electrically charging or discharging the EV battery by the EVSE.

The charging includes applying a charging voltage V to the connector and limiting the charging voltage V by an upper voltage limit $V_{Lim\_EVPresent}$ and wherein the discharging includes applying a charging voltage V to the connector and limiting the charging voltage V by a lower voltage limit $V_{Lim\_EVPresent}$. The upper voltage limit $V_{Lim\_EVPresent}$ is determined as a function of the EV Present Voltage.

```
insert Connector
from EVSE in          S1
Car-Connector

EVSE determining
battery voltage or    S2
battery saturation

                      S3
EVSE charges          S3.1
battery

EVSE limits
charging Voltage      S3.2
to an upper limit
Vi in EV present
```

Fig. 2

**(Cont. next page)**

(52) Cooperative Patent Classification (CPC): (Cont.)
    B60L 2260/44

**Description**

FIELD OF INVENTION

The present disclosure is in the field of electromobility, and in particular regards a method for charging or discharging an EV battery of an Electrical Vehicle, EV, and an Electrical Vehicle Supply Equipment, EVSE, for that purpose. The method preferably regards DC-charging or -discharging the EV battery.

BACKGROUND OF INVENTION

A sufficiently developed charging infrastructure is important for the transition to electromobility. The charging infrastructure includes a sufficient number of Electric Vehicle (EV) charging stations, also known as "Electric Vehicle Supply Equipment" (EVSE).

Due to the aim of charging batteries as quickly as possible, today's fast charging stations commonly charge with direct current (DC). Since the vehicle batteries are charged with high voltages and currents, in some cases with 800V at 500A, in order to enable rapid charging and thus continued driving of the vehicle even with high-capacity vehicle batteries, an EVSE and the components involved in the charging must be able to withstand high loads.

In particular, the connections between the EVSE and the vehicle, including the connector of the EVSE and the inlet of the EV, are subject to high loads. In order to protect these devices, the flow of electricity to the Vehicles battery should only be enabled if it has been communicated between the vehicle and the EVSE that the charging cable connector is properly connected and mechanically locked.

Nevertheless, it has been observed in practice that there is a possibility that in case of a fault and/or user errors, electrical arcs may occur. For example, an arc may occur if the connection has failed to lock properly and/or if the charging cable connector is unlocked and disconnected too quickly. While a vehicle should normally lock the connection, some vehicles are not locking properly, so that an operator may be able to separate the connector from the inlet during charging. Another possible scenario is wear and deterioration of the electrical contacts of the inlet and/or connector, e.g., by dirt, moisture or corrosion, foreign objects, and/or welding effects due to hot spots. Arcs could also occur due to other circumstances. Although modern charging stations are usually designed to minimize the risk of arcs, there may still be some unusual scenarios that could lead to occurrence of arcs. An electric arc can be harmful and (further) damage electrical contacts of connector and/or of the inlet.

For example, even if an arc occurs only briefly, it is capable of causing relevant damage to the connector or premature wear of the high-current connector contacts at high voltages and currents. Such damage reduces the service life of EVSE connectors and can, as a consequence, make it impossible to use a charging station.

It is desired to address these problems and reduce a risk of arcs and their adverse consequences at least to some extent.

SUMMARY OF INVENTION

In order to address the foregoing and other potential problems, embodiments of the present disclosure propose, in a first aspect, a method is provided for charging an EV battery of an Electrical Vehicle, EV, using an Electrical Vehicle Supply Equipment, EVSE. The method comprises electrically coupling a connector of the EVSE to an inlet of the EV; determining by the EVSE an EV Present Voltage provided by the EV battery at the inlet; and electrically charging the EV battery by the EVSE, wherein the charging includes applying a charging voltage V to the connector. The method further comprises limiting the charging voltage V by an upper voltage limit $V_{Lim\_EVPresent}$, wherein the upper voltage limit $V_{Lim\_EVPresent}$ is determined as a function of the EV Present Voltage.

In a second aspect, an Electrical Vehicle Supply Equipment, EVSE, is configured to carry out a method according to the first aspect.

Herein, the invention is illustrated with respect to charging. It is understood that the analogous process can also be carried out for discharging and/or cycling the battery.

BRIEF DESCRIPTION OF DRAWINGS

Embodiments of the present disclosure will be presented in the sense of examples and their advantages are explained in greater detail below, with reference to the accompanying drawings, wherein:

FIG. 1 shows a schematic illustration of a situation in which an electric arc may occur during charging;

FIG. 2 shows a block diagram of a method according to the application;

DETAILED DESCRIPTION OF EMBODIMENTS

Hereinafter, the principle and spirit of the present disclosure will be described with reference to illustrative embodiments. All these embodiments are given merely for the skilled in the art to better understand and further practice the present disclosure, but not for limiting the scope of the present disclosure. Also, features illustrated or described as part of one aspect or embodiment may be used with another aspect or embodiment.

In the interest of clarity, not all features of an actual implementation are described in this specification. It will of course be appreciated that in the development of any such actual embodiment, numerous implementation-specific decisions should be made to achieve the developer's specific goals, such as compliance with system-related and business-related constraints, which will vary from one implementation to another. Moreover, it will be appreciated that such a development effort might be complex and time-consuming, but would nevertheless be a routine undertaking for those of ordinary skill in the art having the benefit of this disclosure.

According to an aspect, the present disclosure can be applied to charging stations for electrically powered vehicles and, in particular, in DC charging stations intended for charging vehicle traction batteries with high voltages and high capacities.

In these, generally measures are in place against arcing. For example, the connection between connector and inlet is generally locked before charging is enabled by the EVSE after an additional delay. Also, the locking is released only after the charging has stopped, again after a delay. But there may still be cases in which an arc could occur as mentioned above.

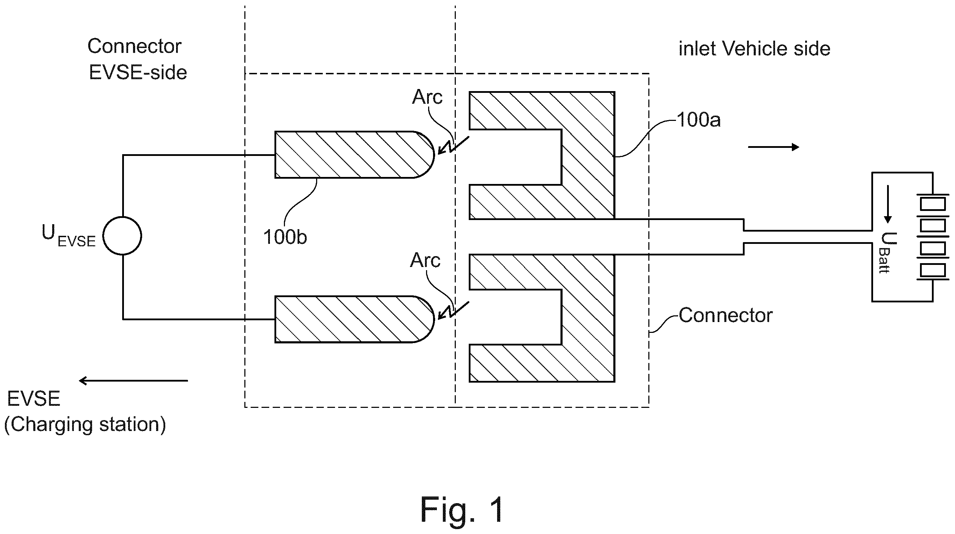

Fig. 1 illustrates a situation in which an arc can occur while an EVSE charges an EV battery. The pins and sockets may be switched between EVSE and EV, or be mixed (e.g., at least one pin and at least one socket for each). When the EVSE charges the EV battery, a charging voltage $V_{EVSE}$ is applied to the EVSE's connector 100b, and is applied to the EV's battery via the EV's inlet 100a. When the EVSE's connector 100b and the EV's inlet 100a are separated during charging for some reason, as illustrated in Fig. 1, an arc may occur and be sustained for prolonged time due to the voltage difference between the EVSE's connector 100b (which is at a voltage defined by $V_{EVSE}$) and the EV's inlet 100a (which is at the EV Present Voltage given by the EV's battery voltage $V_{Batt}$). There may be some control procedure in place to limit the arc by stopping the charging process, but these control procedures are in some instances effective only at time intervals after which the arc may already have done some damage.

Therefore, according to an aspect of the invention, a risk of an arc, as illustrated in Fig. 1, may be further reduced by limiting the charging voltage V by an upper voltage limit $V_{Lim\_EVPresent}$, wherein the upper voltage limit $V_{Lim\_EVPresent}$ is determined as a function of the EV Present Voltage provided by the EV battery (also simply referred to as battery) at the inlet. By limiting the charging voltage V in this manner, the risk and/or extent of an arc can be significantly reduced. Namely, and arc occurs when the connection between connector and inlet is separated during charging (while charging current is flowing). In this situation the voltage at the inlet due to the EV battery will be defined by the EV Present Voltage provided by the EV battery at the inlet (will be at least approximately equal to the EV Present Voltage). By limiting the charging voltage V by an upper voltage limit $V_{Lim\_EVPresent}$ being a function of the EV Present Voltage, the voltage difference between the connector and the inlet can be controlled by this upper limit. Thereby, initiation and extent of electrical arcs can be limited or even suppressed even in a scenario in which the connection between connector and inlet is separated during charging.

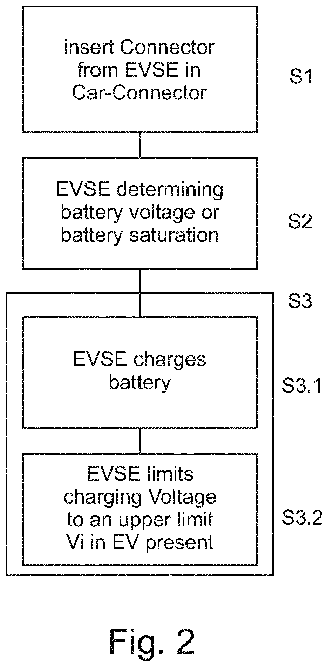

Fig.2 shows a block diagram illustrating an example a method of the invention for charging an EV battery of an Electrical Vehicle, EV, using an Electrical Vehicle Supply Equipment, EVSE. The method comprises a step S1 of electrically coupling a connector of the EVSE to an inlet of the EV; a step S2 of determining by the EVSE an EV Present Voltage provided by the EV battery at the inlet; and a step S3 of electrically charging the EV battery by the EVSE. Within step S3, a charging voltage V is applied to the connector (step 3.1). Thereby, the charging voltage V is limited by an upper voltage limit $V_{Lim\_EVPresent}$ (step 3.2). This upper voltage limit $V_{Lim\_EVPresent}$ is determined as a function of the EV Present Voltage. Steps 3.1 and 3.2 are performed together as part of step S3, and not necessarily in sequence after one another. Likewise, step S2 can be performed not only once at the beginning of charging, but can be continued (e.g., be performed continuously or at least intermittently) during the charging (step S3).

Next, some further aspects of the invention are described.

According to an aspect, the method may comprise electrically coupling a connector of the EVSE to an inlet of the EV. The EVSE is generally connectable to the EV to be charged using a high-current cable with the connector, and the vehicle is connectable to the EVSE with an inlet, these components being adapted for the occurring high charging currents and voltages.

The connector and the inlet can generally have further contacts that enable the EVSE to communicate with the EV and/or vice versa. These contacts can be used, for example, to initiate a locking of the charging plug on the vehicle or to transmit corresponding electrical data of the vehicle accumulator in order to enable the EVSE to set suitable charging parameters.

Further, the charging method may further comprise a step of determining an EV Present Voltage provided by the EV battery at the inlet. The EV Present Voltage may be provided as the difference between positive and negative inlet contacts, or between ground and an inlet contact. The EV present voltage may change slowly over time, due to the charging/discharging process or due to other reasons. The algorithm may therefore be adapted to adjust the $V_{Lim\_EVPresent}$ over time The EV present voltage may be determined in various manners.

In one example, the EV present voltage may be determined by measuring the EV battery voltage. The EV present voltage may be determined by measuring the EV battery voltage applied to the inlet (the inlet voltage due to the EV battery). The measurement may be carried out by the EVSE, e.g., by the EVSE measuring the voltage applied by the EV battery to the inlet. The measurements may for example be carried out via at least one controller present in the EVSE, which also controls the voltage and current values of the power converters or buck/boost converters present in the EVSE, as well as evaluates sensor inputs, for example for fault detection.

In another example, the measurement may be carried out by the EV and then communicated to the EVSE, e.g., by the EV measuring the EV battery voltage (the EV battery voltage applied to the inlet, the inlet voltage due to the EV battery) and communicating the result, or a value derived therefrom, to the EVSE, after the EV has entered a communication status with the EVSE. This example illustrates an aspect, that the EV Present Voltage may be determined by receiving a charging parameter of the EV battery from the EV by the EVSE. According to an aspect, the charging parameters of the battery in the vehicle may be transmitted to the charging station via communication contacts in the charging plug. According to an aspect, the EV Present Voltage may be received by the EVSE from the EV.

When the EV battery is electrically charged by the EVSE, the charging includes applying a charging voltage V to the connector. The charging may be DC charging. The charging may be a high-voltage charging. The charging voltage may be at least 50V, preferably at least 400V-800V. A charging current may be at least 1A, preferably at least 500A. According to an aspect, the charging may be interrupted in intervals for determining an EV Present Voltage.

Further, the method comprises limiting the charging voltage V by an upper voltage limit $V_{Lim\_EVPresent}$, this upper voltage limit $V_{Lim\_EVPresent}$ being determined as a function of the EV Present Voltage. Thereby, $V_{Lim\_EVPresent}$ is imposed as a maximum allowable voltage, and a condition is actively enforced ensuring that the charging voltage V (e.g., a setpoint for the charging voltage V) is limited to be below or at most equal to $V_{Lim\_EVPresent}$.

According to an aspect, $V_{Lim\_EVPresent}$ (and thereby the charging voltage) may be limited such that a potential difference between the charging voltage and the battery vehicle voltage is below an arc generating condition.

According to an aspect, the upper voltage limit $V_{Lim\_EVPresent}$ is determined as a function of the EV Present Voltage that imposes an arc-limiting condition. For example, the function may define a predetermined maximum voltage difference between the upper voltage limit $V_{Lim\_EVPresent}$ and the EV Present Voltage, so that the upper voltage limit never exceeds $V_{Lim\_EVPresent}$ by more than the predetermined maximum offset voltage. Thus, the upper voltage limit $V_{Lim\_EVPresent}$ may be determined as a function of the EV Present Voltage so that $V_{Lim\_EVPresent}$ never exceeds EV Present Voltage plus the predetermined maximum offset voltage. This predetermined offset voltage may be at most 50V, preferably at most 30 V, more preferably 20V. The predetermined offset voltage may be also applied at least, when discharging.

According to an aspect, the upper voltage limit $V_{Lim\_EVPresent}$ is determined by adding a positive offset voltage (or a negative offset voltage when discharging) $V_{Offset}$ to the EV Present Voltage, the offset voltage being at most 50V, preferably at most 30 V, more preferably at most (or equal to) 20V. The offset voltage may be a fixed voltage, but it may also variable and for example depend on further conditions such as the EV Present Voltage charging current or charging status, or on external conditions such as temperature and/or humidity.

Thereby, a voltage difference between the current voltage of the battery and the charging voltage supplied by the EVSE is limited by $V_{Offset}$. This limitation has the effect that an arc is strongly suppressed. For example, an arc may not occur at all for these voltage differences, or may at least be very unlikely to occur and/or at least remaining short-lived.

Thus, according to an aspect, $V_{Lim\_EVPresent}$ is chosen such that a potential difference between the loading voltage and the EV Present Voltage is below or equal a predetermined offset voltage (e.g., 20V). This limitation on the potential difference has a limiting effect on any arc that may develop in spite of other precautions.

The battery voltage changes dynamically during the charging process: For example, the final discharge voltage of the battery may be well below the battery's final charge voltage. Therefore, according to an aspect, the EV present voltage is determined throughout the charging, for example continuously or at least in intervals. Thereby, it is possible to dynamically adapt the upper voltage limit $V_{Lim\_EVPresent}$ (and optionally the voltage offset $V_{Offset}$) to the changing vehicle battery voltage. Further, there may be a lower limit of $V_{Lim\_EVPresent}$ for discharging, to limit the voltage of an arc that may occur on a hot-disconnect

On the other hand, the battery voltage only changes dynamically but normally relatively slowly during the charging process. It is therefore not always necessary to continuously monitor the battery voltage. It is also possible to apply a time delay for limiting the charging voltage V by the upper voltage limit $V_{Lim\_EVPresent}$. The time delay may in examples be at least 10 ms, preferably at least 30 or 50 ms or even 100 ms. The time delay may be in examples also 100ms, 200ms, 500ms, 1s depending on the expected voltage rise that is considered normal

This delay is particularly useful when the EV Present Voltage is determined by measuring the voltage at the EV inlet. In this case, when an arc develops, the voltage measured at the EV inlet may rise to the level of $V_{Lim\_EVPresent}$. By imposing the delay, it is ensured that $V_{Lim\_EVPresent}$ does not increase too quickly due to the rise in the perceived EV Present Voltage in case of an arc (in this example, due to the rise of the voltage measured at the EV inlet), so that any arc remains limited.

According to an aspect, the Voltage $V_{EVSE\_Target}$ may be determined using a minimum of $V_{Lim\_EVPresent}$ and an EV target voltage, $V_{EV\_Target}$, received from the EV. There may be other upper limits such as $V_{EVSE\_MAX}$, the EVSE's upper voltage limit.

According to an aspect, the charging voltage V may be applied to the connector using an EVSE target voltage, $V_{EVSE\_Target}$, as a setpoint for the charging voltage V, and the EVSE target voltage is limited by the upper voltage limit $V_{Lim\_EVPresent}$. In an illustrative example not belonging to the invention, a setpoint for the charging voltage V is set in a manner independent of the EV Present Voltage, for example as

$$V_{EVSE\_Target} = min(V_{EV\_Target}, V_{EVSE\_MAX}),$$

wherein $V_{EV\_Target}$ (sometimes also referred to as $V_{EV\_Req}$) is the voltage requested by the electric vehicle, and $V_{EVSE\_MAX}$ is the EVSE's upper voltage limit. According to an embodiment of the invention, this setpoint may instead be set as

$$V_{EVSE\_Target} = min(V_{EV\_Target}, V_{EVSE\_MAX}, V_{Lim\_EVPresent}),$$

wherein $V_{Lim\_EVPresent}$ is the upper voltage limit determined from the EV Present Voltage.

This setpoint may be used, for example, in a constant current or constant voltage control, or in some other control scheme.

According to an aspect, a charging method for the BEV battery may use at least one of constant current control and constant voltage control (may be according to the CC method and/or to the CV method) or a constant power control.

According to an aspect, the EVSE may be configured to determine an arc generating condition based on the determined EV Present Voltage (e.g., being determined as the measured voltage at the inlet). Thereby, the EVSE can be enabled to recognise the presence (or likely presence) of dielectric breakdown by an arc. Various conditions can be used for this purpose, for example a steep increase or decrease in the EV Present Voltage in a short amount of time, or some other pattern. Suitable pattern(s) and signatures for an arc can also be determined by machine learning. Such conditions can be stored in a memory of the controller of the ESVE. When an arc or likely arc is determined in this or another manner, the EVSE may stop the charging process.

According to an aspect, an Electrical Vehicle Supply Equipment EVSE is configured to carry out the method according to any of the previously embodiments. Thus, the EVSE may have a controller with a processor and a memory, and the memory may contain instructions for carrying out the method by the EVSE.

According to an aspect, in the charging method previously disclosed, the upper voltage limit $V_{Lim\_EVPresent}$ may be determined to be dependent on the charge or discharge current. For instance a fixed offset + R * I, where R may be an expected resistance and I is a charge/discharge current.

According to an aspect, an EVSE charging interface conductor and an EV charging interface conductor, respectively, are or comprise at least one of the following:

(a) a connector and an inlet (b) a pantograph and a pantograph-receiving conductor such as a wire or rail. The vehicle may be a truck, a car, or a railway vehicle such as a train or a subway.

The upper voltage limit $V_{Lim\_EVPresent}$ may be determined based on (depending on) the charge or discharge current. The upper voltage limit $V_{Lim\_EVPresent}$ may be determined based on (to be dependent on) the charge or discharge current. For example, the upper voltage limit $V_{Lim\_EVPresent}$ may be determined to be linearly dependent on the charge or discharge current, the linear dependence also including a possible fixed offset. Thus, upper voltage limit $V_{Lim\_EVPresent}$ may be at least partially determined according to the formula $V_{Lim\_EVPresent} = V_0 + R * I$, where $V_0$ is a fixed offset, R is an expected resistance and I is a charge/discharge current.

The above method may describe one operation mode of the EVSE, but the EVSE may also be operable in other operation modes in which the charging voltage V is not necessarily limited as described herein, or in which the limitation is at least reduced, e.g., by increasing the predetermined offset voltage. For example, the EVSE may in normal circumstances be operated in the mode described herein, but for certain vehicles (e.g., vehicles known to reliably avoid possible causes of an arc) or certain circumstances meeting predetermined conditions (e.g., a ultrafast-charging condition or a low-battery-voltage condition), another mode of operation may be selected in which the limitation is reduced or omitted. On the other hand, in some further operation modes there may be further, for example increased or partially different, limitations to the charging voltage V compared to those described herein. According to a particular aspect, the EVSE is exclusively operable or operated with the charging voltage V being limited by the upper voltage limit $V_{Lim\_EVPresent}$, as described herein.

**Claims**

1. A method for charging or discharging an EV battery of an Electrical Vehicle, EV, using an Electrical Vehicle Supply Equipment, EVSE, the method comprising:

   - Electrically coupling an EVSE charging interface conductor of the EVSE to an EV charging interface conductor of the EV;
   - Determining, by the EVSE, an EV Present Voltage provided by the EV battery at the inlet; and
   - At least one of electrically charging or discharging the EV battery by the EVSE, wherein
   - the charging includes applying a charging voltage V to the connector; and limiting the charging voltage V by an upper voltage limit $V_{Lim\_EVPresent}$, and wherein

   the discharging includes applying a charging voltage V to the connector; and limiting the charging voltage V by a lower voltage limit $V_{Lim\_EVPresent}$, and wherein

   - the upper voltage limit $V_{Lim\_EVPresent}$ is determined as a function of the EV Present Voltage.

2. The method according to claim 1, wherein the EV Present Voltage is determined at regular intervals.

3. The method according to any of the previous claims, wherein the upper voltage limit $V_{Lim\_EVPresent}$ is determined as a function of the EV Present Voltage so that $V_{Lim\_EVPresent}$ is larger than the EV Present Voltage and at most the EV Present Voltage + 50 V.

4. The method according to any of the previous claims, wherein the upper voltage limit $V_{Lim\_EVPresent}$ is determined by adding a positive offset voltage $V_{Offset}$ to the EV Present Voltage, the offset voltage being at most 50V, preferably at most 30 V, more preferably 20V.

5. The method according to any of the previous claims, wherein a time delay is applied for limiting the charging voltage V by the upper voltage limit $V_{Lim\_EVPresent}$

6. The method according to claim 5, wherein the time delay is at least 10 ms, preferably at least 30 or even 50 ms.

7. The method according to any of the previous claims, wherein the EV Present Voltage is determined by measuring the EV battery voltage.

8. The method according to any of the previous claims, wherein the EV Present Voltage is determined by receiving a charging parameter of the EV battery from the EV by the EVSE.

9. The method according to any of the previous claims, wherein $V_{EVSE\_Target}$ is determined using a minimum of $V_{Lim\_EVPresent}$ and an EV target voltage, $V_{EV\_Target}$, received from the EV.

10. The method according to any of the previous claims, wherein the upper voltage limit $V_{Lim\_EVPresent}$ is determined to be at most a predetermined offset voltage above the EV Present Voltage, the predetermined offset voltage being preferably at most 50V, more preferably at most 30 V, more preferably 20V.

11. The method according to any of the previous claims, wherein a charging method for the BEV battery uses at least one of constant current control and constant voltage control.

12. The method according to any of the previous claims, wherein the loading current is interrupted to determine the EV Present Voltage.

13. The method according to any of the previous claims, wherein the EVSE is configured to determine an arc generating condition based on the determined EV Present Voltage.

14. The method according to any of the previous claims, wherein the upper voltage limit $V_{Lim\_EVPresent}$ is determined based on the charge or discharge current.

15. An Electrical Vehicle Supply Equipment, configured to carry out the method according to any of the previous claims.

Fig. 1

insert Connector
from EVSE in
Car-Connector

S1

EVSE determining
battery voltage or
battery saturation

S2

S3

EVSE charges
battery

S3.1

EVSE limits
charging Voltage
to an upper limit
Vi in EV present

S3.2

# Fig. 2

Europäisches
Patentamt
European
Patent Office
Office européen
des brevets

## EUROPEAN SEARCH REPORT

**Application Number**

EP 24 15 9438

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/081489 A1 (GERBER JOHN A [US] ET AL) 14 March 2019 (2019-03-14) * paragraphs [0015] - [0017], [0020], [0021], [0023], [0026], [0028] - [0036]; figures 1A,1B,2,3A,4A,4B * | 1-15 | INV. B60L53/14 B60L53/62 B60L3/00 B60L53/16 B60L53/30 |
| X | JP 2011 067041 A (PANASONIC CORP) 31 March 2011 (2011-03-31) * paragraphs [0038], [0039], [0044], [0050], [0051], [0055] - [0089], [0095]; figures 1,2 * | 1-15 | B60L55/00 B60L58/15 B60L53/66 |
| A | US 2022/063434 A1 (KING JR WILLIAM A [US] ET AL) 3 March 2022 (2022-03-03) * paragraphs [0020], [0023], [0027], [0040], [0044], [0045]; figures 1,8,9,10 * | 13 | ADD. B60L3/12 |
| A | US 2019/366852 A1 (ZHANG YUAN [US] ET AL) 5 December 2019 (2019-12-05) * paragraphs [0018] - [0021], [0025], [0028], [0031] - [0034], [0039], [0044], [0045]; figures 1-4 * | 1-15 | TECHNICAL FIELDS SEARCHED (IPC) |
| A | US 2017/274784 A1 (NAGAKURA HAYATO [JP] ET AL) 28 September 2017 (2017-09-28) * paragraphs [0008], [0018] - [0020], [0024] - [0029], [0032], [0035] - [0100]; figures 1-7 * | 1-15 | B60L G01R |
| A | US 2021/101501 A1 (NEITZ MARC [DE] ET AL) 8 April 2021 (2021-04-08) * paragraphs [0022] - [0025], [0040] - [0042], [0063] - [0067], [0089] - [0091], [0102]; figures 1,5,6B * | 1-15 | |

The present search report has been drawn up for all claims

| Place of search | Date of completion of the search | Examiner |
|---|---|---|
| The Hague | 16 August 2024 | Bronski, Bartlomiej |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 606 631 A1**

## ANNEX TO THE EUROPEAN SEARCH REPORT
## ON EUROPEAN PATENT APPLICATION NO.

EP 24 15 9438

This annex lists the patent family members relating to the patent documents cited in the above-mentioned European search report.
The members are as contained in the European Patent Office EDP file on
The European Patent Office is in no way liable for these particulars which are merely given for the purpose of information.

16-08-2024

| Patent document cited in search report | Publication date | Patent family member(s) | Publication date |
|---|---|---|---|
| US 2019081489 A1 | 14-03-2019 | NONE | |
| JP 2011067041 A | 31-03-2011 | NONE | |
| US 2022063434 A1 | 03-03-2022 | EP 3960528 A1 | 02-03-2022 |
| | | US 2022063434 A1 | 03-03-2022 |
| US 2019366852 A1 | 05-12-2019 | CN 110556889 A | 10-12-2019 |
| | | DE 102019114715 A1 | 05-12-2019 |
| | | US 2019366852 A1 | 05-12-2019 |
| US 2017274784 A1 | 28-09-2017 | CN 106797126 A | 31-05-2017 |
| | | EP 3188340 A1 | 05-07-2017 |
| | | JP 6308301 B2 | 18-04-2018 |
| | | JP WO2016031075 A1 | 27-07-2017 |
| | | US 2017274784 A1 | 28-09-2017 |
| | | WO 2016031075 A1 | 03-03-2016 |
| US 2021101501 A1 | 08-04-2021 | US 2021101501 A1 | 08-04-2021 |
| | | WO 2022130010 A1 | 23-06-2022 |

EPO FORM P0459

For more details about this annex : see Official Journal of the European Patent Office, No. 12/82